# FASCICULE DE BREVET EUROPEEN

(11) **EP 0 318 382 B1**
(45) Date de publication et mention de la délivrance du brevet: **29.12.1993**
(21) Numéro de dépôt: 88402952.1
(22) Date de dépôt: 24.11.1988
(51) Int. Cl.: G01S 13/34, F42C 13/04

(54) **Détecteur radioaltimétrique et fusée de proximité equipée d'un tel détecteur**
Funkhöhenmessdetektor und Annäherungszünder mit einem solchen Detektor
Radioaltimeter detector and proximity fuse therefor

(30) Priorité: 27.11.1987 FR 8716492
(43) Date de publication de la demande: 31.05.1989
(73) Titulaire: ETIENNE LACROIX - TOUS ARTIFICES SA, F-31600 Muret (FR)
(72) Inventeur: David, Jacques, F-31380 Montastruc (FR); Crampagne, Raymond, F-31200 Toulouse (FR); Baricos, Jean, F-31520 Ramonville Saint Agne (FR)
(74) Mandataire: Martin, Jean-Jacques

(56) Documents cités:
- EP-A- 0 028 895
- EP-A- 0 066 168
- DE-A- 3 332 328
- FR-A- 2 289 875
- FR-A- 2 513 831
- US-A- 3 761 946
- US-A- 3 798 590
- US-A- 3 805 165
- US-A- 4 040 357
- US-A- 4 059 052
- US-A- 4 620 192
- INTERNATIONAL CONFERENCE RADAR '87, Londres, 19-21 octobre 1987, pages 525-529; M. LANGE et al.: "A millimeter-wave low-range radar altimeter for helicopter applications - experimental results"
- PROCEEDINGS OF THE IEEE, vol. 73, no. 2, février 1985, pages 325-339, IEEE, New York, US; S.J. RABINOWITZ et al.: "Applications of digital technology to radar"

## Description

La présente invention concerne le domaine des détecteurs de proximité. Elle trouve notamment application dans la conception des fusées de proximité pour munitions.

On sait que différents principes de détection de proximité sont utilisables en théorie pour la conception des fusées de proximité. Parmi ces principes de détection on citera : l'utilisation de l'effet Doppler, l'utilisation de radioaltimètre à oscillateur modulé en fréquence, l'utilisation de radar à impulsions, l'utilisation d'ultra sons, l'utilisation d'une détection optoélectronique...

Les fusées de proximité sont généralement construites sur le principe de l'effet Doppler. L'utilisation de cet effet permet d'obtenir un ensemble de détection relativement simple. Cependant, l'utilisation de l'effet Doppler conduit à une grande dispersion de la hauteur de déclenchement. Cette dispersion résulte du fait que la détection de proximité par utilisation de l'effet Doppler procède par discrimination de l'amplitude en puissance du signal retour. Or, cette puissance est liée au coefficient de réflexion de l'obstacle considéré qui varie très largement en fonction de la nature de l'obstacle. Par ailleurs, la détection par effet Doppler ne peut être utilisée sur les projectiles lents dans la mesure où l'effet Doppler alors obtenu n'est pas exploitable. En conclusion, les détecteurs à effet Doppler, bien que séduisants en théorie de par leur simplicité, ne donnent pas entière satisfaction dans la mesure où ils fournissent une grande incertitude sur la distance de déclenchement et ne peuvent équiper les projectiles lents.

On a tenté de remédier à ces inconvénients en développant, pour les fusées de proximité, des détecteurs du type radioaltimètre.

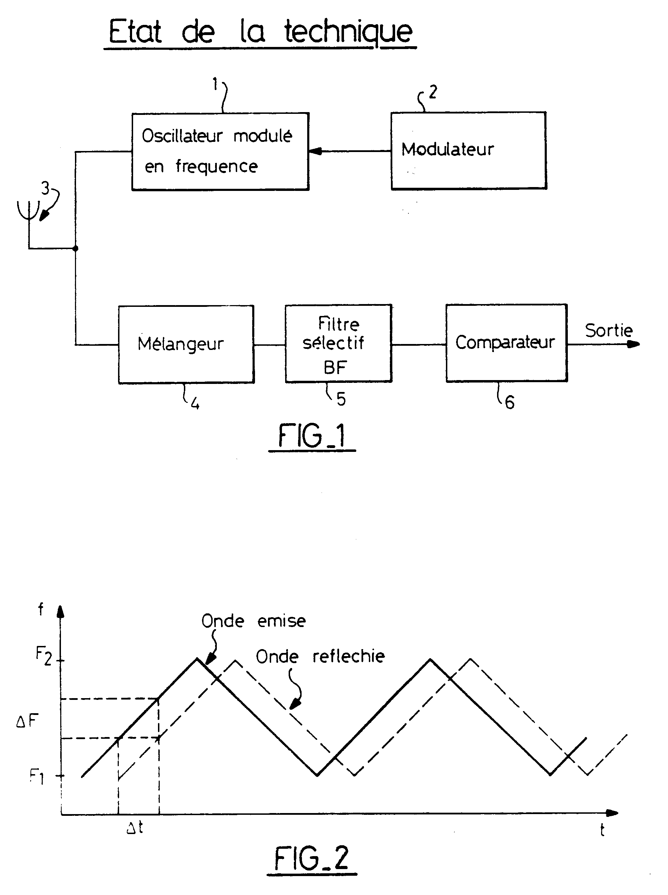

La structure d'un tel détecteur du type radioaltimètre, connue ne soi, est illustrée sur la figure 1 annexée.

On aperçoit sur cette figure 1 annexée un oscillateur 1 modulé en fréquence par un modulateur 2. L'oscillateur 1 modulé en fréquence est couplé à une antenne 3. Ainsi, une onde modulée en fréquence est rayonnée vers la cible. Une fraction du signal issu de l'oscillateur-émetteur 1 est dirigée vers un mélangeur 4. Ce dernier reçoit par ailleurs l'écho réfléchi par la cible. Si l'on suppose que le sytème équipè du radioaltimètre est fixe par rapport à la cible, l'écho correspond à l'onde émise, retardée par le temps de parcours aller-retour entre l'antenne 3 et la cible. On obtient ainsi en sortie du mélangeur 4 un battement de fréquence ΔF qui dépend directement du temps de parcours aller-retour de l'onde, donc de la distance séparant le détecteur de la cible. Le signal obtenu en sortie du mélangeur 4 est dirigé vers un circuit discriminateur. Ce circuit discriminateur peut être formé avantageusement d'un filtre sélectif basse fréquence 5 et d'un comparateur 6.

On a par exemple illustré sur la figure 2 en trait continu une modulation linéaire, en dents de scie symétriques, de la fréquence de l'oscillateur-émetteur 1. On a par ailleurs illustré sur la même figure 2, en traits interrompus, l'echo reçu et dirigé sur le mélangeur 4. L'homme de l'art comprendra aisément qu'un même temps de parcours Δt, correspondant à une même distance d séparant le détecteur de la cible, conduit à un même écart de fréquence ΔF. Ainsi dans le cas d'une modulation linéaire de la fréquence de l'oscillateur-émetteur 1 la mesure d'une distance d revient à détecter un battement de fréquence ΔF correspondant en sortie du mélangeur 4. Pour cela il suffit d'accorder le filtre sélectif 5 sur le battement de fréquence ΔF recherché.

L'utilisation d'un détecteur radioaltimétrique conduit à une précision de déclenchement très supérieure à celle obtenue avec des détecteurs utilisant l'effet Doppler. En effet, les détecteurs radioalmétriques sont totalement insensibles au coefficient de réflexion de la cible puisqu'ils procèdent par discrimination d'un battement de fréquence et non point par discrimination d'amplitude en puissance.

Le réglage de la distance de déclenchement d commandée par un détecteur radioaltimétrique peut être obtenu par simple contrôle de la pente du signal basse fréquence de modulation de la fréquence de l'oscillateur-émetteur.

De plus, les détecteurs radioaltimétriques peuvent équiper des projectiles lents. En effet, le battement de fréquence ΔF recherché en sortie du mélangeur 4 est lié essentiellement au temps de parcours aller-retour du signal généré par l'oscillateur-émetteur 1 et est par contre très peu dépendant de la vitesse du projectile équipé. (On précisera ultérieurement l'influence de l'effet Doppler sur la mesure).

Malgré tous ces avantages théoriques présentés par les détecteurs radioaltimétriques, on constate dans la pratique que ces détecteurs radioaltimétriques sont peu utilisés de nos jours pour la réalisation de fusées de proximité et qu'en revanche les détecteurs utilisant l'effet Doppler restent les plus utilisés.

Cet abandon des détecteurs radioaltimétriques au profit des détecteurs Doppler semble dû au fait que les radioaltimètres conduisaient jusqu'ici à des réalisations encombrantes et très onéreuses dans la mesure où il était nécessaire de trier avec le plus grand soin les différents composants du circuit, en particulier les composants de l'oscillateur-émetteur 1, afin d'obtenir une loi de modulation correspondant précisant à la loi recherchée.

Le document INTERNATIONAL CONFERENCE RADAR'87, Londres, 19-21 Octobre 1987, page 525-529, M. LANGE et al. décrit un détecteur radio-altimétrique pour hélicoptère comprenant un oscillateur émetteur, un modulateur apte à moduler la fréquence de l'oscillateur émetteur selon une loi établie, ledit modulateur comprenant une mémoire numérique contenant une série de valeurs définissant la loi de modulation en fréquence de l'oscillateur émetteur, lesquelles valeurs tiennent compte des caractéristiques précises de l'oscillateur quelles que soient les disparités des composants utilisés pour la conception de l'oscillateur, un mélangeur recevant le signal issu de l'oscillateur émetteur et un signal écho correspondant réfléchi par une cible, un circuit discriminateur connecté en sortie du mélangeur et comprenant un filtre accordé sensiblement sur un battement de fréquence lié au temps de parcours aller et retour du signal issu de l'oscillateur émetteur et réfléchi sur la cible, un convertisseur numérique analogique intercalé entre l'oscillateur émetteur et la mémoire numérique.

La présente invention a maintenant pour but de proposer un nouveau détecteur du type radioaltimètre, qui tout en présentant une grande précision de déclenchement soit nettement plus économique que les réalisations antérieures.

Ce but est atteint, dans le cadre de la présente invention, grâce à un détecteur radioaltimétrique du type connu en soi comprenant :
- un oscillateur-émetteur,
- un modulateur apte à moduler la fréquence de l'oscillateur-émetteur selon une loi établie, ledit modulateur comprenant une mémoire numérique contenant une série de valeurs définissant la loi de modulation en fréquence de l'oscillateur-émetteur, lesquelles valeurs tiennent compte des caractéristiques précises de l'oscillateur, quelles que soient les disparites des composants utilisés pour la conception de l'oscillateur,
- un mélangeur recevant le signal issu de l'oscillateur-émetteur et un signal écho correspondant réfléchi par une cible,
- un circuit discriminateur connecté en sortie du mélangeur et comprenant un filtre accordé sensiblement sur un battement de fréquence ΔF lié au temps de parcours aller-retour du signal issu de l'oscillateur-émetteur et réfléchi sur la cible,
- un convertisseur numérique/analogique intercalé entre l'oscillateur-émetteur et la mémoire numérique et
- une horloge qui pilote ladite mémoire numérique,
caractérisé par le fait qu'il comprend en outre une mémoire auxiliaire numérique contenant une série de valeurs définissant une loi de variation de battement radioaltimétrique en fonction de la loi de modulation en fréquence de l'oscillateur-émetteur contenue dans la mémoire numérique.

L'utilisation d'une mémoire numérique constituant la base du modulateur, permet d'utiliser un oscillateur-émetteur classique réalisé avec des composants non triés et d'adapter la loi de modulation spécifiquement à l'oscillateur utilisé. En d'autres termes, l'utilisation d'une mémoire numérique permet de diminuer l'encombrement et le coût du détecteur, car elle évite un tri sévère des composants nécessaires pour la réalisation de l'oscillateur-émetteur et du module définissant la loi de modulation.

D'autres caractéristiques, buts et avantages de la présente invention apparaîtront à la lecture de la description détaillée qui va suivre, et en regard des dessins annexés donnés à titre d'exemples non limitatifs et sur lesquels :
- les figures 1 et 2 précédemment décrites illustrent l'état de la technique,
- la figure 3 représente une vue schématique sous forme de blocs fonctionnels d'un détecteur radioaltimétrique conforme à la présente invention,
- la figure 4 représente un exemple de réalisation d'un module oscillateur-émetteur et mélangeur conforme à la présente invention,
- la figure 5 représente une vue schématique, sous forme de blocs fonctionnels d'un mode de réalisation perfectionné conforme à la présente invention,
- les figures 6A et 6B illustrent une modulation linéaire en fréquence de l'oscillateur et le battement de fréquence F correspondant,
- les figures 7A et 7B illustrent une modulation parabolique en fréquence de l'oscillateur et le battement de fréquence F correspondant.

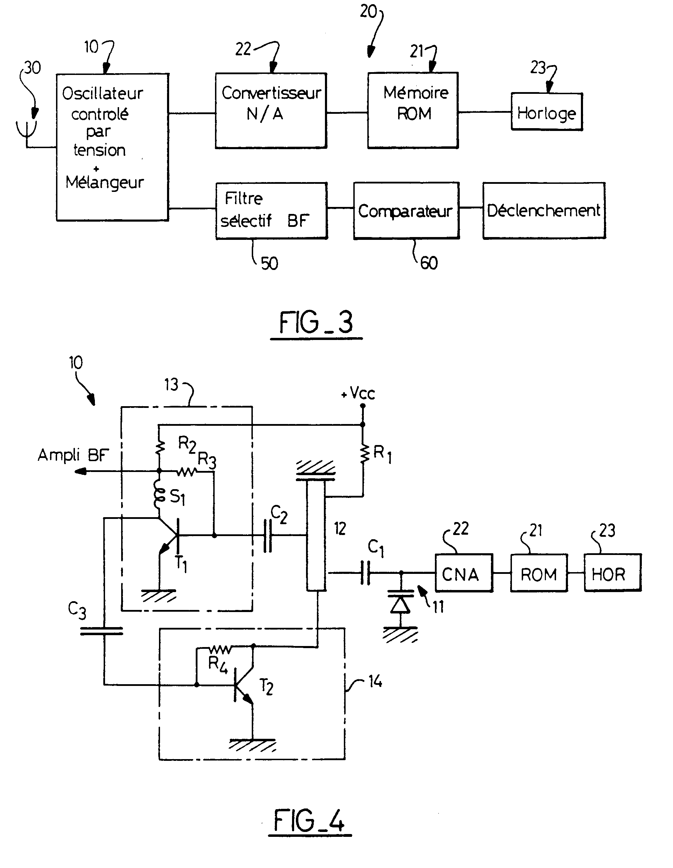

On aperçoit sur la figure 3 un module 10 couplé à une antenne 30 et servant à la fois d'oscillateur contrôlé par tension et de mélangeur, de façon comparable aux modules 1 et 4 illustrés sur la figure 1 et précédemment évoqués.

La sortie de l'étage mélangeur 10 attaque un filtre sélectif basse fréquence 50 lui-même relié en entrée d'un comparateur 60 de façon similaire aux modules 5 et 6 représentés sur la figure 1 et précédemment évoqués.

Comme indiqué précédemment, selon la présente invention, le modulateur 20 comprend une mémoire numérique 21. Celle-ci attaque l'entrée de commande de l'oscillateur contrôlé par tension 10 par l'intermédiaire d'un convertisseur numérique/analogique 22. La mémoire 21 est pilotée par une horloge 23. De préférence, la mémoire numérique 21 est du type mémoire ROM.

La mémoire numérique 21 contient une série de valeurs appliquées cycliquement, grâce au pilotage de l'horloge 23, au convertisseur numérique analogique 22 et de là à l'oscillateur 10, pour définir la loi de modulation en fréquence de ce dernier. Les valeurs contenues dans la mémoire numérique 21 tiennent compte des caractéristiques précises de l'oscillateur 10 quelles que soient les disparités des composants utilisés pour la conception de cet oscillateur.

On va maintenant décrire la structure du module oscillateur-émetteur et mélangeur 10 illustré sur la figure 4. Pour l'essentiel, ce module 10 comprend un varactor 11 (diode à capacité variable), un résonateur en λ/4 12, un étage 13 servant d'amplificateur basse fréquence, amplificateur UHF et mélangeur, et un étage 14 servant d'amplificateur UHF.

Le varactor 11 est commandé par la sortie du convertisseur numérique analogique 22. Le varactor 11 est relié au résonateur en λ/4 12 par l'intemédiaire d'une capacité de liaison C1. Le résonateur en λ/4 est relié à une borne d'alimentation positive +Vcc par l'intermédiaire d'une résistance de polarisation R1. L'étage amplificateur BF, UHF, et mélangeur 13 comprend un transistor T1 du type NPN, deux résistances R2, R3 et une self S1. Le transistor T1 est monté en émetteur commun. Sa base est reliée au résonateur 12 en λ/4 par l'intermédiaire d'une capacité de liaison C2. Les résistances R2 et R3 sont reliées en série entre la borne +Vcc et la base du transistor T1. La self S1 est montée entre le collecteur du transistor T1 et le point commun aux résistances R2 et R3. La self S1 permet d'isoler le battement de fréquence ΔF, basse fréquence, (correspondant à la différence de fréquence instantanée entre l'onde UHF générée par l'oscillateur et l'écho reçu), du signal UHF. Le battement de fréquence ΔF est donc prélevé au point commun aux résistances R2, R3 et la self S1, et dirigé vers le filtre sélectif BF 50, le cas échéant un amplificateur basse fréquence intercalé.

Le collecteur du transistor T1 est rebouclé par ailleurs sur le résonateur 12 en λ/4 par l'intermédiaire de l'étage amplificateur UHF 14. Ce dernier comprend un transistor T2, de type NPN, monté en émetteur commun et une résistance R4. Le collecteur du transistor T1 est relié à la base du transistor T2 par l'intermédiaire d'une capacité de liaison C3. La résistance R4 relie la base et le collecteur du transistor T2. Le collecteur du transistor T2 attaque le résonateur en λ/4 12.

Bien entendu le schéma du module 10 illustré sur la figure 4 n'est donné qu'à titre d'exemple non limitatif. On notera cependant la compacité et la simplicité du mode de réalisation représenté sur la figure 4.

Le résonateur en λ/4 12 peut servir directement d'élément rayonnant, ou le cas échéant une antenne peut être couplée au résonateur 12.

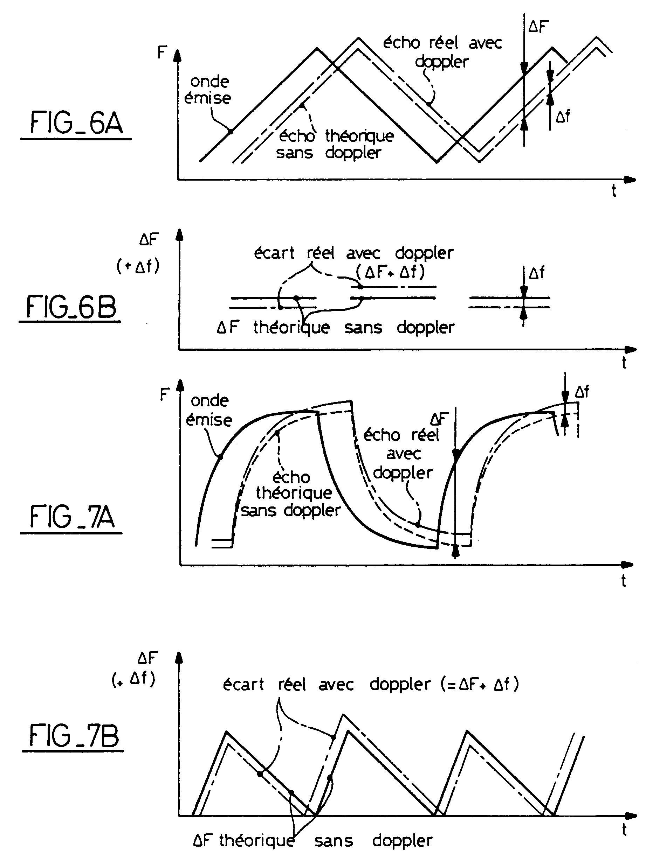

La loi de modulation en fréquence de l'oscillateur 10 mémorisée dans la mémoire numérique 21 peut correspondre à une modulation linéaire, comme illustré en trait continu sur la figure 6A. Dans ce cas, le battement de fréquence ΔF obtenu en sortie du mélangeur 10 reste constant pour une même distance d séparant le détecteur de la cible, comme illustré en trait continu sur la figure 6B.

La modulation linéaire définie par la mémoire numérique 21 peut d'ailleurs correspondre à une modulation en dents de scie symétriques comme illustrée sur la figure 6A, ou encore à une modulation en dents de scie non symétriques.

Cependant, la loi de modulation définie par les valeurs contenues dans la mémoire numérique 21 n'est pas limitée a une modulation linéaire.

De façon connue en soi, la loi de modulation peut par exemple être du type sinusoïdale, parabolique ou encore pseudoaléatoire.

On a illustré en traits pleins sur la figure 7A une modulation parabolique en fréquence de l'oscillateur et sur la figure 7B le battement ΔF correspondant.

De telles lois de modulation non linéaire sont par exemple évoquées dans le document US-A-3 109 172, auquel on se reportera utilement pour bien comprendre le principe de détection altimétrique par modulation en fréquence non linéaire de l'oscillateur-émetteur.

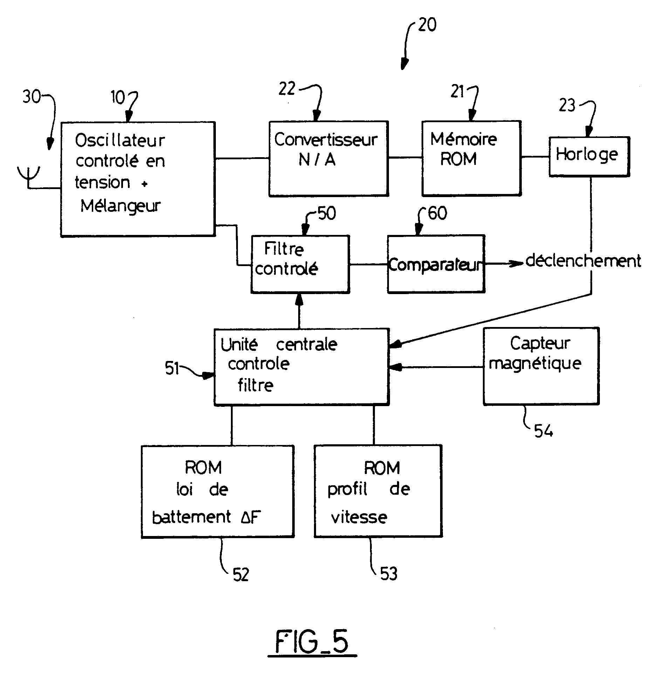

Cependant, dans le cas où la modulation en fréquence de l'oscillateur 10 est non linéaire, le battement en fréquence ΔF obtenu en sortie de l'étage mélangeur 10 varie au cours d'une période de modulation pour une même distance d séparant le détecteur de la cible, dans la mesure où la pente de la loi de modulation n'est pas constante. De ce fait, lorsque la loi de modulation en fréquence de l'oscillateur-émetteur 10 est non linéaire, il est souhaitable d'adapter en conséquence les fréquences de coupure du filtre 50. Pour cela, comme illustré sur la figure 5, la présente invention propose dans un mode de réalisation préférentiel d'utiliser un filtre 50 contrôlé en tension et piloté par une unité centrale 51. Cette unité centrale 51 est par ailleurs reliée à une mémoire numérique 52 (de type ROM) qui contient des valeurs définissant l'évolution de consigne du battement en fréquence ΔF, pour une distance d de détection spécifique, correspondant à la loi de modulation définie dans la mémoire numérique 21. Ainsi, par exemple, pour une loi de modulation parabolique, le battement en fréquence ΔF issu de l'étage mélangeur 10, dû à la détection radioaltimétrique, évoluant linéairement pour une même distance d comme illustré sur la figure 7B, la loi de battement ΔF mémorisée en consigne dans la mémoire numérique 52 correspondra à une loi linéaire.

Dans le cas d'une modulation en fréquence d'allure sinusoïdale, de l'oscillateur émetteur 10, le battement en fréquence issu de l'étage mélangeur 10 évolue sinusoïdalement pour une même distance séparant le détecteur de la cible. De ce fait, dans le cas d'une modulation en fréquence sinusoïdale de l'oscillateur émetteur, la loi de battement ΔF mémorisée en consigne dans la mémoire numérique 52 est d'allure sinusoïdale.

Par généralisation dans le cas d'une modulation pseudoaléatoire en fréquence de l'oscillateur-émetteur 10, la loi de battement ΔF mémorisée en consigne dans la mémoire numérique 52 tient compte de la loi d'évolution du battement en fréquence ΔF issu de l'oscillateur-émetteur 10 pour une même distance d séparant le détecteur de la cible.

Dans les explications qui précèdent on n'a pas tenu compte du battement de fréquence Δf lié à l'effet Doppler du au mouvement relatif détecteur/cible. En effet, ce battement Δf lié à l'effet Doppler peut être négligé en utilisant une pente de modulation de fréquence de l'oscillateur-émetteur telle que le battement ΔF dû à la détection radioaltimétrique (et correspondant à la différence instantanée entre la fréquence de l'onde émise par l'oscillateur-émetteur 10 et la fréquence de l'onde retardée reçue sur le mélangeur après réflexion sur la cible), soit très supérieur au battement de fréquence Δf dû à l'effet Doppler.

Cependant le battement de fréquence Δf lié à l'effet Doppler se superpose au battement ΔF. Pour améliorer la précision de la mesure, on peut donc prendre en compte ce battement Δf lié à l'effet Doppler. Dans ce cas pour éviter que le filtre 50 ne rejette le battement Δf il est au contraire avantageux de déterminer la pente de modulation de l'oscillateur-émetteur 10 de telle sorte que le battement en fréquence ΔF obtenu en sortie du mélangeur 10 et du à la détection radioaltimétrique, (c'est-à-dire la différence instantanée entre la fréquence de l'onde émise par un oscillateur-émetteur théoriquement immobile par rapport à la cible et la fréquence de l'onde reçue après réflexion sur la cible), soit de l'ordre de grandeur du battement Δf du à l'effet Doppler.

A titre d'exemple dans le cas d'un détecteur se déplaçant à une vitesse de 200 m/s, pour une fréquence moyenne de l'onde émise de l'ordre de 10 GHz, le battement Δf du à l'effet Doppler est de l'ordre de 13 kHz. Pour permettre au filtre 50 de prendre en compte à la fois le battement en fréquence ΔF dû à la détection radioaltimétrique et le battement en fréquence Δf dû à l'effet Doppler, on peut déterminer la pente de modulation en fréquence de l'oscillateur-émetteur 10 de telle sorte que le battement en fréquence ΔF dû à la détection radioaltimétrique soit de l'ordre de 50 à 100 kHz.

Par ailleurs, dans la mesure où la vitesse du projectile évolue au' cours de la trajectoire, le battement Δf, dû à l'effet Doppler évolue également largement. Dans ce cas, lorsque le battement Δf dû à l'effet Doppler n'est pas négligeable par rapport au batttement ΔF dû à la détection radioaltimétrique, il est avantageux, comme illustré sur la figure 5, de mémoriser dans une mémoire numérique 53 (de type ROM) le profil de vitesse du système équipé ; ce profil de vitesse détermine une loi de variation du battement Δf dû à l'effet Doppler en fonction de la fréquence (moyenne ou instantanée) de l'onde émise.

L'unité centrale 51 applique alors sur le filtre contrôlé 50 un signal de commande tenant compte à la fois de la loi de battement ΔF mémorisée dans la mémoire 52 et du battement Δf dû à l'effet Doppler correspondant à la vitesse instantanée du système déduite du profil de vitesse mémorisée dans la mémoire 53. On notera que le battement Doppler Δf se retranche du battement ΔF lorsque la pente de modulation en fréquence de l'oscillateur est positive. Par contre le battement Doppler Δf s'ajoute au battement ΔF lorsque la pente de modulation en fréquence de l'oscillateur est négative (voir figures 6A, 6B, 7A et 7B).

De façon avantageuse, une cible réelle peut être discriminée d'un obstacle naturel, tel qu'un buisson ou un arbuste traversé par le système équipé du détecteur altimétrique conforme à l'invention grâce à un capteur magnétique 54 associé au détecteur. L'utilisation d'un capteur magnétique 54 s'avère tout particulièrement avantageuse lorsque le détecteur altimétrique équipe un projectile devant être mis à feu à une distance déterminée d'un corps métallique de grand volume, tel qu'un char.

Lorsque le détecteur altimétrique conforme à l'invention doit équiper une munition tirée à hauteur du sol, par exemple une munition anti-char, il est nécessaire que l'écho utile dans la direction de la cible soit d'amplitude nettement supérieure à l'écho parasite venant du sol. Il est alors avantageux d'utiliser une antenne possédant un gain élevé dans la direction du déplacement. Lorsqu'une rotation du projectile est combinée au déplacement, il est de plus souhaitable d'utiliser une polarisation circulaire.

Le détecteur radioaltimétrique illustré sur la figure 3 (dont l'oscillateur 10 est supposé être modulé linéairement en fréquence) génère un signal de validation en sortie du comparateur 60 apte à assurer le déclenchement de la fusée lorsque les deux conditions suivantes sont réunies :
- le battement en fréquence ΔF obtenu en sortie du mélangeur tombe dans la bande passante du filtre sélectif BF 50 et correspond à la distance de la cible recherchée, et
- l'amplitude de l'écho de la cible utile, détectée par le comparateur 60 est suffisante.

Ce contrôle de l'amplitude de l'écho reçu permet non seulement de discriminer un écho utile dans l'axe du déplacement d'un écho parasite radial, mais également de lever les ambiguités de distance, c'est-à-dire de discriminer le retard τ du à une distance d recherchée des retards τ + nT où T représente la période de modulation, qui correspondent à des distances plus grandes mais au même battement ΔF. Cependant, ce contrôle de l'amplitude de l'écho a simplement pour but de contrôler que le détecteur est placé dans une plage de distance par rapport à la cible englobant la distance de déclenchement d recherchée et ne peut être assimilé à la détection fondamentale d'amplitude dans le cas d'un système à effet Doppler selon lequel il s'agit non point de verifier que l'amplitude du signal tombe dans une plage donnée, mais de vérifier que l'amplitude du signal correspond à une valeur précise.

Le détecteur altimétrique plus élaboré illustré sur la figure 5 génère le signal de validation en sortie du comparateur 60, en vue du déclenchement de la fusée lorsqu'en sus de la vérification d'amplitude sur l'écho reçu effectuée par le comparateur 60, le battement de fréquence obtenu à la sortie du mélangeur 10 correspond au cumul des battemetns de fréquence Δf et ΔF déterminés grâce aux mémoires 52 et 53, et correspond donc à la bande passante adaptée du filtre 50 (on rappelle que le battement Δf se retranche ou s'ajoute au battement ΔF selon que la pente de modulation en fréquence est positive ou négative).

En option, comme indiqué précédemment, le signal de validation peut n'être généré en sortie du comparateur 60 qu'après activation d'un capteur magnétique 54 associé. La sécurité du système peut être encore augmentée en équipant le détecteur d'une sécurité chronométrique assurant la mise en service du détecteur altimétrique seulement après un temps déterminé après l'instant initial de lancement du système ou munition équipé. Ce temps déterminé est défini sur la base d'une approximation de la distance séparant le système de lancement de la cible, mesuré par exemple par télémètre, et de la vitesse de déplacement.

Dans les explications qui précèdent on suppose que le signal de validation est généré en sortie du comparateur 60 dès que le battement en fréquence obtenu à la sortie du mélangeur 10 correspond instantanément à la bande passante du filtre sélectif 50.

Pour améliorer encore la détection on peut procéder non point par détection de l'atteinte d'une consigne à un instant donné, mais vérifier en dynamique que le battement en fréquence à la sortie du mélangeur correspond à l'évolution attendue.

En d'autres termes, lorsque le battement Δf du à l'effet Doppler est négligeable par rapport au battement ΔF, la détection en dynamique consistera à vérifier que l'évolution du battement ΔF en sortie du mélangeur 10 correspond à l'évolution de consigne mémorisée dans la mémoire 52.

Lorsque le battement Δf du à l'effet Doppler n'est pas négligeable par rapport au battement ΔF, la détection en dynamique consistera à vérifier que l'évolution du battement en sortie du mélangeur 10 correspond au cumul des effets définis par la loi de consigne mémorisée dans la mémoire 52 (pour ΔF) et la loi de consigne mémorisée dans la mémoire 53 (pour Δf). On rappelle que le battement Δf se retranche du battement ΔF pour une pente positive de modulation en fréquence et par contre s'ajoute au battement ΔF pour une pente négative de modulation en fréquence.

La détection en dynamique peut être faite sur une période de modulation, une portion de période de modulation ou encore une pluralité de périodes de modulation.

Le détecteur altimétrique conforme à la présente invention est susceptible d'équiper de nombeux systèmes, en particulier de nombreux types de munitions, tels que bombes d'aviation, roquettes, missiles, sous-munitions, cartouches d'avion, obus ou autres.

Le détecteur altimétrique de proximité conforme à l'invention a pour avantage d'être de taille réduite, d'être insensible à l'incidence du projectile, de déclencher à hauteur d'obstacle constante, aisément réglable et indépendante de la nature de la cible, et de fonctionner à toute vitesse.

Par ailleurs, le détecteur altimétrique conforme à la présente invention présente une bonne immunité par rapport aux contre-mesures. Cette immunité résulte entre autres de la nature du signal utilisé, à savoir un signal modulé en fréquence, de la nécessité de détecter simultanément plusieurs informations précises pour opérer le déclenchement (ΔF, Δf, niveau d'amplitude, le cas échéant détection magnétique), du retard de mise en fonctionnement par rapport au lancement imposé en option par une sécurité chronométrique. Enfin, on notera que la loi de modulation en fréquence de chaque détecteur est définie en fonction des caractéristiques spécifiques de l'oscillateur-émetteur considéré. En d'autres termes, la modulation n'est pas centrée sur une fréquence standard. Elle peut varier notablement et de façon aléatoire entre deux détecteurs.

Bien entendu la présente invention n'est pas limitée aux modes de réalisation particulier qui viennent d'être décrits mais s'étend à toutes variantes conformes à son esprit.

## Revendications

1. Détecteur radioaltimétrique du type comprenant
- un oscillateur-émetteur (10),
- un modulateur (20) apte à moduler la fréquence de l'oscillateur-émetteur selon une loi établie, le modulateur (20) comprenant une mémoire numérique (21) contenant une série de valeurs définissant la loi de modulation en fréquence de l'oscillateur-émetteur (10), lesquelles valeurs tiennent compte des caractéristiques précises de l'oscillateur (10), quelles que soient les disparités des composants utilisés pour la conception de cet oscillateur
- un mélangeur recevant le signal issu de l'oscillateur-émetteur (10) et un signal écho correspondant réfléchi par une cible,
- un circuit discriminateur (50, 60) connecté en sortie du mélangeur, et comprenant un filtre (50) accordé sensiblement sur un battement de fréquence ΔF lié au temps recherché de parcours aller-retour du signal issu de l'oscillateur-émetteur et réfléchi sur la cible,
- un convertisseur numérique/analogique (22) intercalé entre l'oscillateur-émetteur (10) et la mémoire numérique (21),
- une horloge (23) qui pilote la mémoire numérique (21),
caractérisé par le fait qu'il comprend en outre une mémoire auxiliaire numérique (52) contenant une série de valeurs définissant une loi de variation de battement radioaltimétrique ΔF en fonction de la loi de modulation en fréquence de l'oscillateur-émetteur contenue dans la mémoire numérique (21).

2. Détecteur radioaltimétrique selon la revendication 1, caractérisé par le fait que la mémoire numérique (21) définit une modulation linéaire en fréquence pour l'oscillateur-émetteur.

3. Détecteur radioaltimétrique selon la revendication 1, caractérisé par le fait que la mémoire numérique (21) définit une modulation sinusoïdale en fréquence de l'oscillateur-émetteur (10).

4. Détecteur radioaltimétrique selon la revendication 1, caractérisé par le fait que la mémoire numérique (21) définit une modulation parabolique en fréquence de l'oscillateur-émetteur (10).

5. Détecteur radioaltimétrique selon la revendication 1, caractérisé par le fait que la mémoire numérique définit une modulation pseudo-aléatoire en fréquence de l'oscillateur-émetteur (10).

6. Détecteur radioaltimétrique selon l'une des revendications 1 à 5, caractérisé par le fait qu'il comprend en outre une unité centrale (51) qui pilote un filtre contrôlé (50) connecté en sortie du mélangeur (10) pour adapter la fréquence de coupure du filtre contrôlé (50) en fonction de la loi de variation de battement radioaltimétrique ΔF mémorisée dans la mémoire numérique auxiliaire (52).

7. Détecteur radioaltimétrique selon la revendication 6, caractérisé par le fait que l'unité centrale (51) vérifie en dynamique que l'évolution du battement en fréquence en sortie du mélangeur (10) correspond à la loi de variation de battement radioaltimétrique ΔF mémorisée dans la mémoire numérique auxiliaire (52).

8. Détecteur radioaltimétrique selon l'une des revendications 1 à 7, caractérisé par le fait qu'il comprend en outre une mémoire numérique secondaire (53) contenant une série de valeurs définissant le profil de vitesse du système équipé et de la une loi d'évolution d'un battement Doppler Δf.

9. Détecteur radioaltimétrique selon la revendication 8, caractérisé par le fait qu'il comprend en outre une unité centrale (51) qui pilote un filtre contrôlé, connecte en sortie du mélangeur (10) sur la base des informations contenues dans la mémoire auxiliaire (52) et la mémoire secondaire (53).

10. Détecteur radioaltimétrique selon la revendication 9, caractérisé par le fait que l'unité centrale (51) vérifie en dynamique que l'évolution du battement en fréquence en sortie du mélangeur (10) correspond au cumul du battement radioaltimétrique ΔF et du battement Doppler Δf définis par la mémoire auxiliaire numérique (52) et la mémoire numérique secondaire (53).

11. Détecteur radioaltimétrique selon l'une des revendications 1 à 10, caractérisé par le fait qu'il comprend un comparateur (60) connecté en sortie d'un filtre (50), le comparateur procédant par discrimination d'amplitude.

12. Détecteur radioaltimétrique selon l'une des revendications 1 à 11 caractérisé par le fait que chacune des mémoires numériques utilisées (21, 52 et 53) est du type mémoire ROM.

13. Détecteur radioaltimétrique selon l'une des revendications 1 à 12, caractérisé par le fait que l'oscillateur-émetteur et le mélangeur (10) sont formés d'un varactor (11), d'un résonateur (12), d'un étage transistorisé (13) servant d'ampli BF, d'ampli UHF et de mélangeur, et d'un étage transistorisé (14) servant d'ampli UHF.

14. Détecteur radioaltimétrique selon la revendication 13, caractérisé par le fait que l'étage transistorisé (13) servant d'ampli BF, d'ampli UHF et de mélangeur possède une self (S1) servant à séparer le battement radioaltimétrique ΔF basse fréquence du signal UHF.

15. Détecteur radioaltimétrique selon l'une des revendications 1 à 14, caractérisé par le fait que l'étage transistorisé UHF (14) reboucle la sortie de l'étage transistorisé (13) servant d'ampli BF, d'ampli UHF et mélangeur sur le résonateur (12).

16. Détecteur radioaltimétrique selon l'une des revendications 1 à 15, caractérisé par le fait qu'il comprend en outre une sécurité chronométrique retardant la mise en service du détecteur.

17. Fusée de proximité comprenant un détecteur radioalimétrique conforme à l'une des revendications 1 à 16.

## Claims

1. A radioaltimeter type detector comprising :
an oscillator-transmitter (10);
a modulator (20) suitable for imparting frequency modulation of given characteristic to the oscillator-transmitter, the modulator (20) including digital memory (21) containing a series of values defining the frequency modulation characteristic for the oscillator-transmitter (20), said values taking account of the precise characteristics of the oscillator (10) regardless of the spread of characteristics in the components used in the construction of the oscillator;
a mixer receiving the signal from the oscillator-transmitter (10) and a corresponding echo signal reflected by a target;
a discriminator circuit (50, 60) connected to the output from the mixer and including a filter (50) tuned substantially to the beat frequency ΔF related to the looked-for round trip time for the signal from the oscillator-transmitter after reflection at the target;
a digital-to-analog converter (22) interposed between the oscillator-transmitter (10) and the digital memory (21),
a clock (23) which controls the digital memory (21)
characterized by the fact that it further includes an auxiliary digital memory (52) containing a series of values defining characteristic variation in radioaltimeter beat frequency (ΔF) as a function of the frequency modulation characteristic for the oscillator-transmitter contained in the digital memory (21).

2. A radioaltimeter type detector according to claim 1, characterized by the fact that the digital memory (21) defines a linear frequency modulation characteristic for the oscillator-transmitter (10).

3. A radioaltimeter type detector according to claim 1, characterized by the fact that the digital memory (21) defines a sinusoidal frequency modulation characteristic for the oscillator-transmitter (10).

4. A radioaltimeter type detector according to claim 1, characterized by the fact that the digital memory (21) defines a parabolic frequency modulation characteristic for the oscillator-transmitter (10).

5. A radioaltimeter type detector according to claim 1, characterized by the fact that the digital memory (21) defines a pseudo-random frequency modulation characteristic for the oscillator-transmitter (10).

6. A radioaltimeter type detector according to any one of claims 1 to 5 characterized by the fact that it further includes a central unit (51) for controlling a controlled filter (50) connected to the output of the mixer (10) in order to tune the cut-off frequency of the controlled filter (50) as a function of the characteristic variation in radioaltimeter beat frequency (ΔF) stored in the auxiliary digital memory (52).

7. A radioaltimeter type detector according to claim 6, characterized by the fact that the central unit (51) dynamically verifies that the beat frequency at the output from the mixer (10) varies in a manner which corresponds to the characteristic of variation in radioaltimeter beat frequency ΔF as stored in the auxiliary digital memory (52).

8. A radioaltimeter type detector according to any one of claims 1 to 7, characterized by the fact that it further includes a secondary digital memory (53) containing a series of values defining a speed profile for the system equipped with the detector, and thus a characteristic for change in Doppler beat frequency Δf.

9. A radioaltimeter type detector according to claim 8, characterized by the fact that it further includes a central unit (51) controlling a controlled filter connected to the output from the mixer (10) on the basis of information contained in the auxiliary memory (52) and in the secondary memory (53).

10. A radioaltimeter type detector according to claim 9, characterized by the fact that the central unit (51) dynamically verifies that the change in beat frequency at the output from the mixer (10) corresponds to the combined radioaltimeter beat frequency ΔF and Doppler beat frequency Δf defined by the auxiliary digital memory (52) and by the secondary digital memory (53).

11. A radioaltimeter type detector according to any one of claims 1 to 10, characterized by the fact that it includes a comparator (60) connected to the output from a filter (50), with the comparator operating on the basis of amplitude discrimination.

12. A radioaltimeter type detector according to any one of claims 1 to 11, characterized by the fact that each of the digital memories used (21, 52, and 53) is a read only memory.

13. A radioaltimeter type detector according to any one of claims 1 to 12, characterized by the fact that the oscillator-transmitter and the mixer (10) are constituted by a varactor (11), a resonator (12), a transistor stage (13) serving as a low frequency amplifier, as a UHF amplifier, and as a mixer, and a transistor stage (14) serving as a UHF amplifier.

14. A radioaltimeter type detector according to claim 13, characterized by the fact that the transistor stage (13) serving as a low frequency amplifier, as a UHF amplifier, and as a mixer, includes a choke (S1) for separating the UHF signal from the low frequency radioaltimeter beat frequency ΔF.

15. A radioaltimeter type detector according to any one of claims 1 to 14, characterized by the fact the UHF transistor stage (14) feeds back the output from the transistor stage (13) serving as a low frequency amplifier, as a UHF amplifier, and as a mixer, to the resonator (12).

16. A radioaltimeter type detector according to any one of claims 1 to 15, characterized by the fact that it further includes a time lapse security feature delaying the instant at which the detector is put into operation.

17. A proximity fuse including a radioaltimeter type detector according to any one of claims 1 to 16.

## Patentansprüche

1. Funkhöhenmeßdetektor, vom Typ mit:
- einem Oszillator-Emitter (10),
- einem Modulator (20), der zum Modulieren der Frequenz des Oszillator-Emitters gemäß einem festgelegten Gesetz eingerichtet ist, wobei der Modulator (20) einen Digitalspeicher (21) umfaßt, der eine Serie von Werten enthält, die das Gesetz der Frequenzmodulation des Oszillator-Emitters (10) definieren, welche Werte die präzisen Charakteristiken des Oszillators (10) ungeachtet der Unterschiede der für die Ausbildung dieses Oszillators verwendeten Komponenten berücksichtigen,
- einem Mischer, der das vom Oszillator-Emitter (10) ausgegebene Signal und ein entsprechendes von einem Ziel reflektiertes Echosignal empfängt,
- einer Diskriminierungsschaltung (50, 60), die am Ausgang des Mischers angeschlossen ist und ein Filter (50) umfaßt, das empfindlich auf eine Frequenzverschiebung ΔF eingestellt ist, die mit der Zeit verbunden ist, die für den Hin- und Rückweg des vom Oszillator-Emitter ausgegebenen und am Ziel reflektierten Signals ermittelt wird,
- einem Digital-Analog-Wandler (22), der zwischen dem Oszillator-Emitter (10) und dem Digitalspeicher (21) angeordnet ist,
- einem Taktgeber (23), der den Digitalspeicher (21) steuert,
dadurch gekennzeichnet, daß er ferner einen Zusatzdigitalspeicher (52) umfaßt, der eine Serie von Werten enthält, die ein Variationsgesetz der FunkhöhenmeßVerschiebung ΔF entsprechend dem im Digitalspeicher (21) enthaltenen Frequenzmodulationsgesetz des Oszillator-Emitters definieren.

2. Funkhöhenmeßdetektor nach Anspruch 1, dadurch gekennzeichnet, daß der Digitalspeicher (21) eine lineare Frequenzmodulation für den Oszillator-Emitter definiert.

3. Funkhöhenmeßdetektor nach Anspruch 1, dadurch gekennzeichnet, daß der Digitalspeicher (21) eine sinusförmige Frequenzmodulation des Oszillator-Emitters (10) definiert.

4. Funkhöhenmeßdetektor nach Anspruch 1, dadurch gekennzeichnet, daß der Digitalspeicher (21) eine parabelförmige Frequenzmodulation des Oszillator-Emitters (10) definiert.

5. Funkhöhenmeßdetektor nach Anspruch 1, dadurch gekennzeichnet, daß der Digitalspeicher eine pseudozufällige Frequenzmodulation des Oszillator-Emitters (10) definiert.

6. Funkhöhenmeßdetektor nach einem der Ansprüche 1 bis 5, dadurch gekennzeichnet, daß er ferner eine Zentraleinheit (51) umfaßt, die ein gesteuertes Filter (50) steuert, das am Ausgang des Mischers (10) angeschlossen ist, um die Frequenz des Sperrbereichs des gesteuerten Filters (50) entsprechend dem im Zusatzdigitalspeicher (52) gespeicherten Variationsgesetz der FunkhöhenmeßVerschiebung ΔF anzupassen.

7. Funkhöhenmeßdetektor nach Anspruch 6, dadurch gekennzeichnet, daß die Zentraleinheit (51) dynamisch verifiziert, daß die Entwicklung der Frequenzverschiebung am Ausgang des Mischers (10) dem im Zusatzdigitalspeicher (52) gespeicherten Variationsgesetz der der FunkhöhenmeßVerschiebung ΔF entspricht.

8. Funkhöhenmeßdetektor nach einem der Ansprüche 1 bis 7, dadurch gekennzeichnet, daß er ferner einen zweiten Digitalspeicher (53) umfaßt, der eine Serie von Werten enthält, die das Geschwindigkeitsprofil des vorgesehenen Systems und hiervon ein Entwicklungsgesetz einer DopplerVerschiebung Δf definieren.

9. Funkhöhenmeßdetektor nach Anspruch 8, dadurch gekennzeichnet, daß er ferner eine Zentraleinheit (51) umfaßt, die ein gesteuertes Filter, das am Ausgang des Mischers (10) angeschlossen ist, auf Basis der im Zusatzspeicher (52) und im zweiten Speicher (53) enthaltenen Informationen steuert.

10. Funkhöhenmeßdetektor nach Anspruch 9, dadurch gekennzeichnet, daß die Zentraleinheit (51) dynamisch verifiziert, daß die Entwicklung der Frequenzverschiebung am Ausgang des Mischers (10) der Summe der FunkhöhenmeßVerschiebung ΔF und der DopplerVerschiebung Δf, die durch den Zusatzdigitalspeicher (52) und den zweiten Digitalspeicher (53) definiert werden, entspricht.

11. Funkhöhenmeßdetektor nach einem der Ansprüche 1 bis 10, dadurch gekennzeichnet, daß er einen am Ausgang eines Filters (50) angeschlossenen Komparator (60) umfaßt, wobei der Komparator eine Amplitudendiskriminierung vornimmt.

12. Funkhöhenmeßdetektor nach einem der Ansprüche 1 bis 11, dadurch gekennzeichnet, daß jeder der verwendeten Digitalspeicher (21, 52 und 53) vom ROM-Speichertyp ist.

13. Funkhöhenmeßdetektor nach einem der Ansprüche 1 bis 12, dadurch gekennzeichnet, daß der Oszillator-Emitter und der Mischer (10) aus einem Varaktor (11), einem Resonator (12), einer Transistorstufe (13), die als NF-Verstärker, UHF-Verstärker und Mischer dient, und einer Transistorstufe (14), die als UHF-Verstärker dient, gebildet sind.

14. Funkhöhenmeßdetektor nach Anspruch 13, dadurch gekennzeichnet, daß die als NF-Verstärker, UHF-Verstärker und Mischer dienende Transistorstufe (13) eine Selbstinduktionsspule (S1) aufweist, die zum Trennen der Niederfrequenz-EunkhöhenmeßVerschiebung ΔF vom UHF-Signal dient.

15. Funkhöhenmeßdetektor nach einem der Ansprüche 1 bis 14, dadurch gekennzeichnet, daß die UHF-Transistorstufe (14) den Ausgang der Transistorstufe (13), die als NF-Verstärker, UHF-Verstärker und Mischer dient, mit dem Resonator (12) verbindet.

16. Funkhöhenmeßdetektor nach einem der Ansprüche 1 bis 15, dadurch gekennzeichnet, daß er ferner eine chronometrische Sicherheitsvorrichtung, die die Inbetriebnahme des Detektors verzögert, umfaßt.

17. Näherungszünder, mit einem Funkhöhenmeßdetektor nach einem der Ansprüche 1 bis 16.
